# EUROPEAN PATENT SPECIFICATION

(11) **EP 2 047 518 B1**
(45) Date of publication and mention of the grant of the patent: **01.08.2018**
(21) Application number: 07796597.8
(22) Date of filing: 29.06.2007
(51) Int. Cl.: H01L 31/042, H02S 40/22, H02S 20/23, F24S 23/77

(54) **ARRANGEMENT OF SOLAR CELL AND REFLECTORS**
ANORDNUNG EINER SOLARZELLE UND REFLEKTOREN
DISPOSITION D'UNE CELLULE SOLAIRE ET DES RÉFLECTEURS

(30) Priority: 02.08.2006 US 497765
(43) Date of publication of application: 15.04.2009
(73) Proprietor: Simon, Daniel, Chicago, IL 60640 (US)
(72) Inventor: Simon, Daniel, Chicago, IL 60640 (US)
(74) Representative: Badger, John Raymond
(86) International application number: PCT/US2007/015190
(87) International publication number: WO 2008/016453

(56) References cited:
- US-A- 3 419 434
- US-A- 3 419 434
- US-A- 4 296 736
- US-A- 4 398 530
- US-A- 4 867 134
- US-A- 4 867 134
- US-A- 5 511 537
- US-A- 5 511 537
- US-A- 6 091 017
- US-A1- 2004 000 106

## Description

### BACKGROUND

### Field of Invention

This invention relates generally to solar panels and more specifically to an improved arrangement of a solar cell and reflector in a module or panel.

### Description of the Prior Art

There is a significant interest in the commercial application of solar energy. One of the main obstacles to widespread use of solar energy is the high cost of solar devices, especially solar photovoltaic cells. This is because of the relatively high cost of materials used to convert solar energy (especially relative to reflector material). It is well known in the art to use a solar cell for intercepting sunlight and producing energy of thermal or electrical nature (or a combination of both). A solar cell generally can mean a receiver or thermal absorbing plate (for solar thermal applications) or a solar photovoltaic cell (for solar electrical applications). Cells are frequently connected or joined to other cells either in parallel or in series within a single plane like tiles on a floor, and once a useful number of them are assembled, they are generally enclosed in what is commonly called a module.

A module normally has a transparent cover, parallel to and above the plane of the solar cells, which allows sunlight to enter the module and strike the solar cells. The module will frequently have sides and a backing plate that define a weather tight enclosure that helps shield the solar cell from the elements.

The prior art contains examples of arranging the solar cells within a module. Reflectors are frequently used to minimize regions between active solar cells where entering sunlight would produce no energy. Much of the prior art assumes the solar cells are arranged in a single plane normal to the incoming sunlight and parallel to the transparent cover, such as U.S. Patents Nos. 6,528,716 and 4,316,448 Disadvantages of these types of arrangements primarily include the inefficient or wasteful use of expensive materials.

The prior art also contains examples of more complex geometries where a significant portion of incoming light is reflected from one or more surfaces onto the cell. Some examples of this are U.S. Patent. Nos. 5,538,563. 4,471,763 and 2,904,612 Disadvantages of these types of arrangements are complex geometries or the requirement of mechanical tracking systems which add to the cost of system manufacture and maintenance.

A reflector and solar collector in an angular orientation is taught by Epsy in U.S. Pat. No. 4,120,282. Patent 4,120,282 is hereby incorporated by reference. Espy teaches a complex and variable geometry that depends on user location, which makes mass production difficult. Furthermore, the arrangement described by Espy does not contain protection for the reflector or collector surfaces. The result is that one or both of these surfaces can be easily damaged by the elements. Another example of a reflector and solar collector in an angular orientation is taught in U.S. Pat. No. 4,398,530.

### SUMMARY OF THE INVENTION

The present invention relates to a method and apparatus for arranging a solar cell and reflector to replace a typical solar cell oriented normal to the incoming sunlight inside a module (i.e. parallel to a module's transparent cover plate or opening). An example not being part of the invention uses a solar cell oriented at around a 45 degree angle to the incoming sunlight, and a reflective surface oriented perpendicular to the cell and at around a 45 degree angle to the incoming sunlight. The solar cell and the mirror are the same length/size and form a V shape where the angle between the sloped sides is around 90 degrees. Any light falling normally on the arrangement will hit the solar cell either directly or after reflection. In an embodiment of the invention, two adjacent reflectors can be used making angles of around 60 degrees and around 30 degrees with respect to the cover or opening. A further alternate embodiment can include a second reflector placed perpendicular at the base of the cell and first reflector pairing also at an approximate 45 degree angle with the cover or opening.

### Objects and Advantages:

The present invention has many advantages over the prior art including, but not limited to:
1. A simple arrangement that allows either more sunlight to be captured with the same area of solar cell, or the same amount of sunlight can be captured with a smaller solar cell.
2. Most prior art practices of module making can remain the same with the present invention, with the exception that a deeper module/enclosure may be needed, as well as a way to support the reflector and solar cell in their new orientation. The wiring or plumbing that is typically built along the back surface of the solar cell, or row of solar cells, is generally unaffected by the new orientation.
3. The reflector and cell arrangement of the present invention are protected from the elements and this arrangement can be used with many types of solar cell technologies and will uniformly illuminate the solar cell surface.
4. The reflector can be designed to reflect only the solar spectrum that generates electricity (for a PV solar cell) but not the infrared parts that might overheat the cell and reduce performance.

### DESCRIPTION OF THE DRAWINGS

Figure 1 shows a perspective view of a prior art arrangement of solar cells in tiled configuration parallel to a module cover.
Figure 2 shows a side view of a reflector and solar cell at a 90 degree angle to each other (below the plane of prior art orientation).
Figure 3 shows a perspective view of multiple rows of reflectors and cells (saw-tooth style) within a module.
Figure 4 shows a side view of reflectors (60 deg and 30deg) and a solar cell at 45 degree angles to the original horizontal cell plane.
Figure 5 shows a perspective view of an array made from the embodiment of Figure 4.
Figure 6 shows a 45 degree angle-in view of an alternate embodiment.
Figure 7 shows embodiment of Figure 6 with a more complex reflector-cell geometry with a new solar cell orientation replaced by a smaller perpendicular mirror and cell set rotated by 90 degrees.

### DETAILED DESCRIPTION OF THE INVENTION

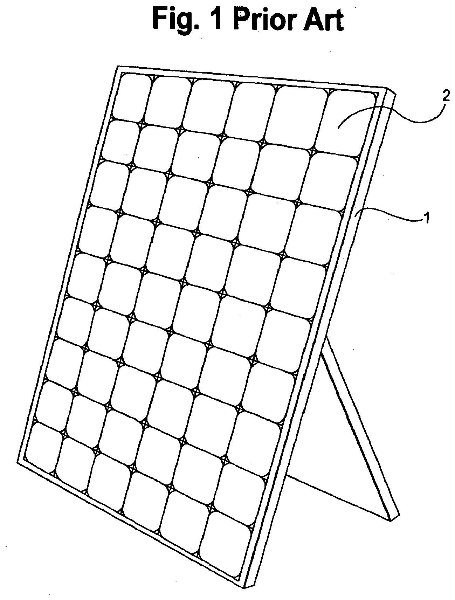

Figure 1 shows a prior art method of making a solar panel. A frame (1) is built and either supported or attached to a roof with flat, tiled panels (2) that contain solar cells. Tiles may have weather-tight covers to protect the cells. This arrangement does not lead to optimum efficiency in the amount of light striking the cells.

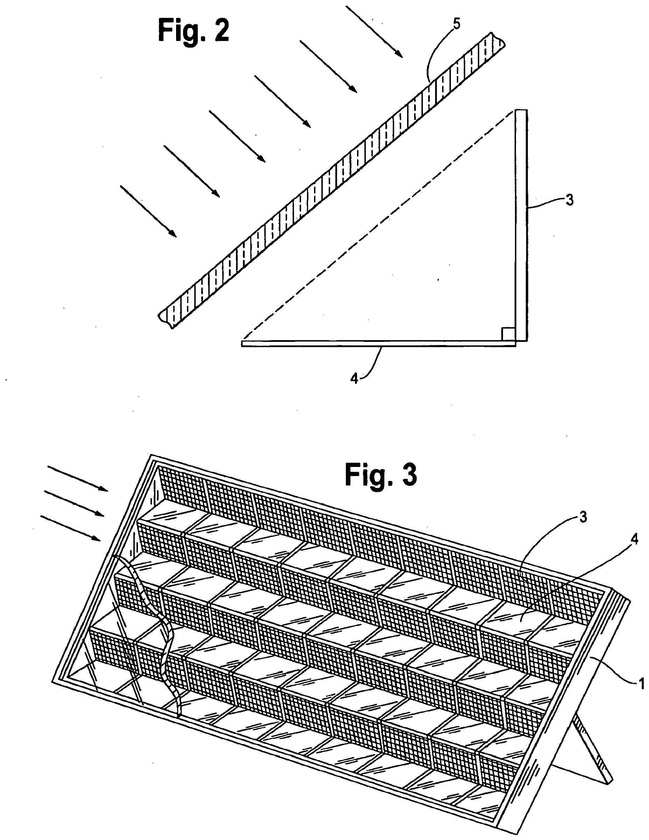

Figure 2 shows a side view of an example not being part of the present invention. A solar cell (3) is rotated at around a 45 degree angle to a module cover (5). A reflector (4), also at around a 45 degree angle to the module cover (5) is located approximately perpendicular to and adjacent to the solar cell (3). The reflector (4) can be equivalent in length and width to the solar cell (3). The reflector (4) and the solar cell (3) form a V-shape with the opening parallel to the module cover (5). Light that enters the module perpendicular to the module cover (5) will hit the solar cell (3) (at a 45 degree angle) directly, or after reflecting off the reflector (4). The solar cell (3) combined with the reflector (4) in this orientation collects the same amount of energy as a cell 30% larger oriented parallel to a module cover as shown in prior art Figure 1.

Figure 3 shows a parametric view of a solar module with a frame (1) holding an array completely populated with a solar cell (3) and reflector (4) pairings, all at a 45 degree angle to module cover. Although each reflector (4) is shown individually (for clarity), a single extended reflector can be used extending from one end of the module to the other in place of the nine reflectors per row shown in Figure 3.

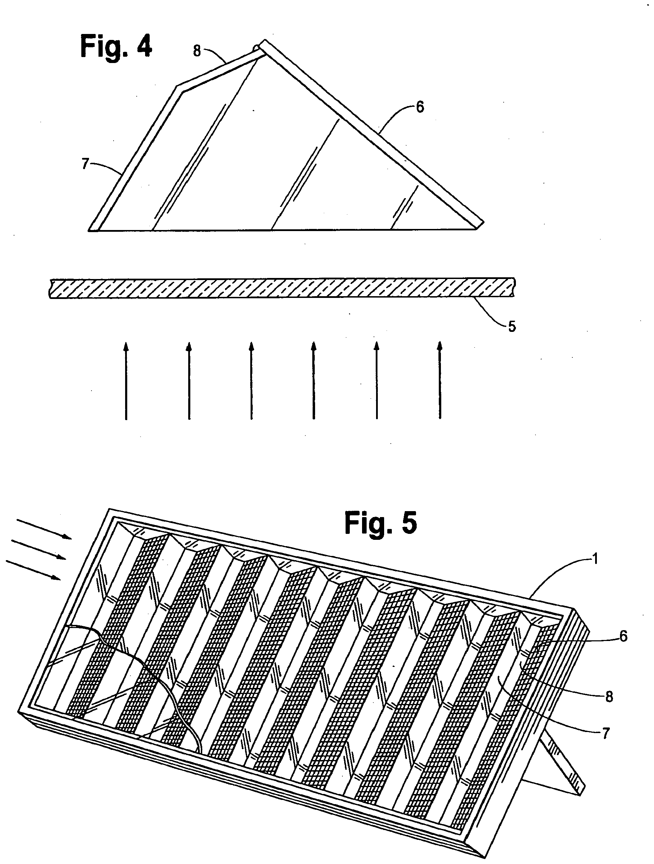

Figure 4 shows a side view of an embodiment of the present invention. Here, a solar cell (6) can generally be longer than the solar cells shown in Figure 3. This solar cell (6) is also rotated at around a 45 degree angle with respect to the module cover (5). A first reflector (7) is rotated at around a 60 degree angle with respect to the module cover (5), and a second reflector (8) makes around a 30 degree angle with the module cover (5). The upper edge of the first reflector (7) is approximately adjacent to the lower edge of the second reflector (8). The lower edge of the first reflector (7) is adjacent to the lower edge of the solar cell (6) forming around a 105 degree angle between the first reflector (7) and the solar cell (6). Figure 5 shows a perspective view of an array made from the cell-reflector arrangement of Figure 4. The frame (1) holds the solar cells (6) and the two reflector parts (7, 8). The alternative embodiment of Figures 4-5 offers an alternative geometry that reflects light on to the solar cell (6) that might not otherwise hit it.

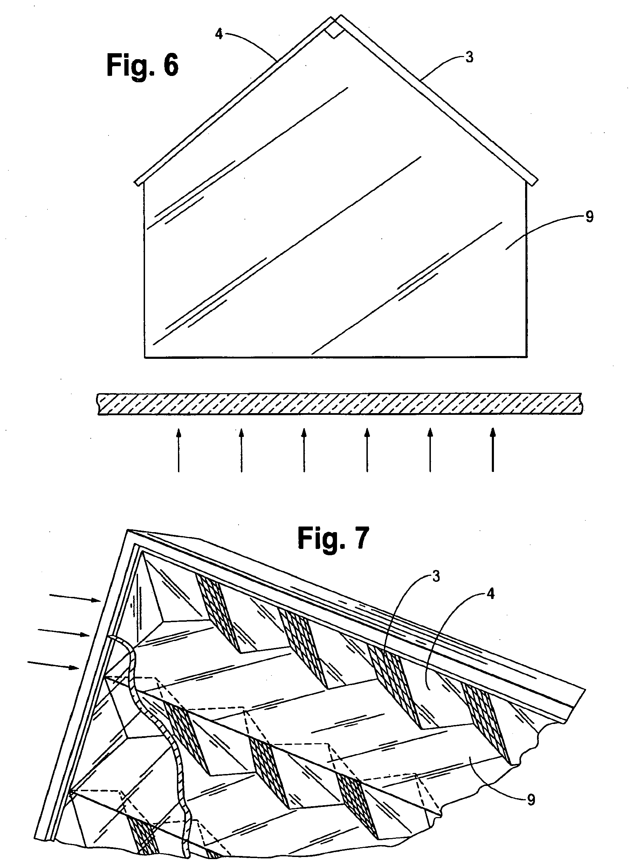

Figures 6-7 show an alternate embodiment of the present invention where the cells (3) and the reflectors (4) are arranged as in Figure 2, but rotated by 90 degrees, and including an additional end reflector (9). This arrangement allows better light collection (higher concentration of light) from a particular set of daily sun angles (the morning-noon solar arc, or the mid-morning to mid-afternoon solar arc, or the noon-afternoon solar arc) for different orientations of the frame (1). Figure 6 is a view looking straight down on the additional reflector (9), and Figure 7 is a perspective view. This embodiment has the advantage of capturing more light from the daily sun angles. Specifically, this embodiment can capture twice as much sunlight per area of solar receiver as the prior art, but only during about half of the day. A solar panel constructed according to this embodiment might practically be located on the east or west facing portions of buildings in locations where prior art panels are impractical due to diurnal shading.

In all of the embodiments the present invention, the reflective surfaces can optionally be designed to not reflect infrared (heating) wavelengths of sunlight onto solar cell if desired. This is especially useful if the cell is a photovoltaic cell that produces less electricity as the cell temperature rises. In this manner, only useful wavelengths are normally directed to the cell from the reflectors.

### INDUSTRIAL APPLICATION

The present invention is particularly useful for providing solar power in the form of electricity or hot fluid for consumer or commercial use. The increased efficiency of the embodiments of the present invention make it superior to prior art products.

## Claims

1. A solar collector of the type used for converting sunlight into electricity or for heating a fluid including an enclosure (1) with four sides and a transparent cover (5) for protecting interior surfaces from the elements **characterised in that** the solar collector comprises:-
a) at least one rectangular solar collecting surface (6) mounted at a 45 degree angle to the transparent cover (5);
b) a pair of reflective surfaces (8,7) in proximity to the solar collecting surface (6) including a first (7) of said pair of reflective surfaces mounted at an angle of between 46-60 degrees to the transparent cover and a second (8) of said pair of reflective surfaces mounted at an angle relative to the transparent cover which is complementary to the angle of the first reflective surface relative to the transparent cover, said second reflective surface comprising two edges one adjacent the first reflective surface (7) and the other adjacent to the solar collecting surface (6) whereby said second reflective surface extends between the first reflective surface and the solar collecting surface.

2. A solar collector according to claim 1, **characterised in that** the solar collecting surface (6) includes a photovoltaic cell for converting light to electricity.

3. A solar collector according to claim 2, **characterised in that** at least one of the reflective surfaces (7,8) have a coating that reflects a band of light wavelengths that the photovoltaic cell converts to electricity, while not reflecting infrared wavelengths that heat said photovoltaic cell.

4. A solar collector according to any one of the preceding claims, **characterised in that** it comprises a plurality of solar collecting surfaces (6) and reflective surfaces (7,8).

5. A light collecting system comprising a frame(1), at least one solar cell (3) secured to the frame (1), and a first reflector (9) secured to the frame (1) **characterised in that** at least one second reflector (4) is secured to the frame (1) and disposed perpendicularly to the first reflector (9) and said at least one solar cell (3) is disposed perpendicularly to the first reflector (9) and second reflector (4).

6. A light collecting system according to claim 5, **characterised in that** it comprises a plurality of second reflectors (4) each perpendicular to the first reflector (9).

7. A light collecting system according to claim 6, **characterised in that** it comprises a plurality of solar cells (3) each perpendicular to the first reflector (9) and the second reflectors (4).

8. A light collecting system according to claim 7, **characterised in that** each of the solar cells (3) is adjacent to one of the second reflectors (4).

9. A light collecting system according to any one of claims 5 to 8, **characterised in that** the first (9) and second (4) reflectors are aluminum.

10. A light collecting system according to any one of claims 5 to 9, **characterised in that** the solar cell (3) is a photovoltaic cell.

11. A light collecting system according to claim 10, **characterised in that** at least one of the first (9) or second (4) reflectors has a coating that reflects a band of light wavelengths which the photovoltaic cell (3) converts to electricity, while not reflecting infrared wavelengths that heat said photovoltaic cell (3).

## Patentansprüche

1. Solarkollektor von solcher Art, wie er zur Umwandlung von Sonnenlicht in Strom oder zum Erhitzen eines Fluids verwendet wird, einschließlich eines Gehäuses (1) mit vier Seiten und einer transparenten Abdeckung (5) zum Schützen von Innenflächen vor den Elementen, **dadurch gekennzeichnet, dass** der Solarkollektor Folgendes umfasst:
a) mindestens eine rechteckige Solarsammelfläche (6), die in einem 45-Grad-Winkel an der transparenten Abdeckung (5) befestigt ist;
b) ein Paar reflektierender Oberflächen (8,7) in der Nähe der Solarsammelfläche (6), einschließlich einer ersten (7) von dem Paar reflektierender Flächen, die in einem Winkel von zwischen 46 und 60 Grad an der transparenten Abdeckung befestigt ist, und einer zweiten (8) von dem Paar reflektierender Flächen, die in Bezug auf die transparente Abdeckung in einem Winkel befestigt ist, der komplementär zu dem Winkel der ersten reflektierenden Fläche zu der transparenten Abdeckung ist, wobei die zweite reflektierende Fläche zwei Kanten umfasst, von denen eine an die erste reflektierende Fläche (7) angrenzt und die andere an die Solarsammelfläche (6) angrenzt, wodurch sich die zweite reflektierende Fläche zwischen der ersten reflektierenden Fläche und der Solarsammelfläche erstreckt.

2. Sonnenkollektor nach Anspruch 1, **dadurch gekennzeichnet, dass** die Solarsammelfläche (6) eine Photovoltaikzelle zum Umwandeln von Licht in Strom beinhaltet.

3. Sonnenkollektor nach Anspruch 2, **dadurch gekennzeichnet, dass** mindestens eine der reflektierenden Flächen (7,8) eine Beschichtung aufweist, die Lichtbandwellenlängen, die von der Photovoltaikzelle in Strom umgewandelt werden, reflektiert, während sie Infrarotwellenlängen, die die Photovoltaikzelle erhitzen, nicht reflektiert.

4. Sonnenkollektor nach einem der vorhergehenden Ansprüche, **dadurch gekennzeichnet, dass** er eine Vielzahl von Solarsammelflächen (6) und reflektierenden Flächen (7, 8) umfasst.

5. Lichtsammelsystem, umfassend einen Rahmen (1), mindestens eine Solarzelle (3), die an dem Rahmen (1) befestigt ist, und einen ersten Reflektor (9), der an dem Rahmen (1) befestigt ist, **dadurch gekennzeichnet, dass** mindestens ein zweiter Reflektor (4) an dem Rahmen (1) befestigt und senkrecht zu dem ersten Reflektor (9) angeordnet ist und die mindestens eine Solarzelle (3) senkrecht zu dem ersten Reflektor (9) und dem zweiten Reflektor (4) angeordnet ist.

6. Lichtsammelsystem nach Anspruch 5, **dadurch gekennzeichnet, dass** es eine Vielzahl von zweiten Reflektoren (4) umfasst, die jeweils senkrecht zu dem ersten Reflektor (9) verlaufen.

7. Lichtsammelsystem nach Anspruch 6, **dadurch gekennzeichnet, dass** es eine Vielzahl von Solarzellen (3) umfasst, die jeweils senkrecht zu dem ersten Reflektor (9) und den zweiten Reflektoren (4) verlaufen.

8. Lichtsammelsystem nach Anspruch 7, **dadurch gekennzeichnet, dass** jede der Solarzellen (3) an einen der zweiten Reflektoren (4) angrenzt.

9. Lichtsammelsystem nach einem der Ansprüche 5 bis 8, **dadurch gekennzeichnet, dass** es sich bei dem ersten (9) und dem zweiten (4) Reflektor um Aluminium handelt.

10. Lichtsammelsystem nach einem der Ansprüche 5 bis 9, **dadurch gekennzeichnet, dass** es sich bei der Solarzelle (3) um eine Photovoltaikzelle handelt.

11. Lichtsammelsystem nach Anspruch 10, **dadurch gekennzeichnet, dass** mindestens einer von dem ersten (9) oder dem zweiten (4) Reflektor eine Beschichtung aufweist, die Lichtbandwellenlängen, die von der Photovoltaikzelle (3) in Strom umgewandelt werden, reflektiert, während sie Infrarotwellenlängen, die die Photovoltaikzelle (3) erhitzen, nicht reflektiert.

## Revendications

1. Capteur solaire du type utilisé pour convertir la lumière du soleil en électricité ou pour chauffer un fluide, comprenant une enceinte (1) avec quatre côtés et une couverture transparente (5) permettant de protéger des éléments les surfaces intérieures, **caractérisé en ce que** le capteur solaire comprend :
a) au moins une surface de captage solaire rectangulaire (6) montée à un angle de 45 degrés par rapport à la couverture transparente (5) ;
b) une paire de surfaces réfléchissantes (8, 7) à proximité de la surface de captage solaire (6) comprenant une première surface réfléchissante (7) de ladite paire de surfaces réfléchissantes montée selon un angle compris entre 46 et 60 degrés par rapport à la couverture transparente et une seconde surface réfléchissante (8) de ladite paire de surfaces réfléchissantes montée selon un angle par rapport à la couverture transparente qui est complémentaire à l'angle de la première surface réfléchissante par rapport à la couverture transparente, ladite seconde surface réfléchissante comprenant deux bords, l'un adjacent à la première surface réfléchissante (7) et l'autre adjacent à la surface de captage solaire (6), selon lesquels ladite seconde surface réfléchissante s'étend entre la première surface réfléchissante et la surface de captage solaire.

2. Capteur solaire selon la revendication 1, **caractérisé en ce que** la surface de captage solaire (6) comprend une cellule photovoltaïque destinée à convertir la lumière en électricité.

3. Capteur solaire selon la revendication 2, **caractérisé en ce qu'**au moins l'une des surfaces réfléchissantes (7, 8) possèdent un revêtement qui réfléchit une bande de longueurs d'onde de lumière que les cellules photovoltaïques convertissent en électricité, tout en ne réfléchissant pas les longueurs d'ondes infrarouges qui chauffent lesdites cellules photovoltaïques.

4. Capteur solaire selon l'une quelconque des revendications précédentes, **caractérisé en ce qu'**il comprend une pluralité de surfaces de captage solaire (6) et de surfaces réfléchissantes (7, 8).

5. Système de captage de lumière comprenant un cadre (1), au moins une cellule solaire (3) fixée au cadre (1) et un premier réflecteur (9) fixé au cadre (1) **caractérisé en ce qu'**au moins un second réflecteur (4) est fixé au cadre (1) et disposé perpendiculairement au premier réflecteur (9) et ladite au moins une cellule solaire (3) étant disposée perpendiculairement au premier réflecteur (9) et au second réflecteur (4).

6. Système de captage de lumière selon la revendication 5, **caractérisé en ce qu'**il comprend une pluralité de seconds réflecteurs (4),chacun perpendiculaire au premier réflecteur (9).

7. Système de captage de lumière selon la revendication 6, **caractérisé en ce qu'**il comprend une pluralité de cellules solaires (3), chacune perpendiculaire au premier réflecteur (9) et aux seconds réflecteurs (4).

8. Système de captage de lumière selon la revendication 7, **caractérisé en ce que** chacune des cellules solaires (3) est adjacente à l'un des seconds réflecteurs (4).

9. Système de captage de lumière selon l'une quelconque des revendications 5 à 8, **caractérisé en ce que** les premiers (9) et seconds (4) réflecteurs sont en aluminium.

10. Système de captage de lumière selon l'une quelconque des revendications 5 à 9, **caractérisé en ce que** la cellule solaire (3) est une cellule photovoltaïque.

11. Système de captage de lumière selon la revendication 10, **caractérisé en ce qu'**au moins l'un des premiers (9) ou seconds (4) réflecteurs possède un revêtement qui reflète une bande de longueurs d'onde de lumière que la cellule photovoltaïque (3) convertit en électricité tout en ne réfléchissant pas les longueurs d'ondes infrarouges qui chauffent ladite cellule photovoltaïque (3).
